Europäisches Patentamt

European Patent Office

Office européen des brevets

(11) Numéro de publication: **0 307 017 B1**

(12) **FASCICULE DE BREVET EUROPEEN**

(45) Date de publication de fascicule du brevet: **13.10.93**　(51) Int. Cl.⁵: **H01J 37/08**, H01J 27/08

(21) Numéro de dépôt: **88201587.8**

(22) Date de dépôt: **21.07.88**

(54) Implanteur d'ions métalliques.

(30) Priorité: **05.08.87 FR 8711130**

(43) Date de publication de la demande:
**15.03.89 Bulletin 89/11**

(45) Mention de la délivrance du brevet:
**13.10.93 Bulletin 93/41**

(84) Etats contractants désignés:
**CH DE FR GB LI NL**

(56) Documents cités:
**EP-A- 0 132 015**
**US-A- 4 714 860**

**NUCLEAR INSTRUMENTS AND METHODS IN PHYSICS RESEARCH, vol. B10/11, no. 1, mai 1985, pages 792-795, partie 2, Elsevier Science Publishers B.V., Amsterdam, NL; C. BURKHART et al.: "Vacuum arc arrays for intense metal ion beam injectors"**

**JOURNAL OF APPLIED PHYSICS, vol. 58, no. 9, 1 novembre 1985, ges 3356-3363, American Institute of Physics, Woodbury, New York, US; M.M. MENON et al.: "Heat loading on the components of multimegawatt ion sources"**

(73) Titulaire: **SOCIETE ANONYME D'ETUDES ET REALISATIONS NUCLEAIRES - SODERN**
**1 Avenue Descartes**
**F-94450 Limeil Brevannes(FR)**

(84) Etats contractants désignés:
**FR**

(73) Titulaire: **N.V. Philips' Gloeilampenfabrieken**
**Groenewoudseweg 1**
**NL-5621 BA Eindhoven(NL)**

(84) Etats contractants désignés:
**CH DE GB LI NL**

(72) Inventeur: **Bernardet, Henri Société Civile S.P.I.D.**
**209, rue de l'Université**
**F-75007 Paris(FR)**
Inventeur: **Thiebaut, Chantal Société Civile S.P.I.D.**
**209, rue de l'Université**
**F-75007 Paris(FR)**

(74) Mandataire: **Chaffraix, Jean et al**
**Société Civile S.P.I.D.**
**156, Boulevard Haussmann**
**F-75008 Paris (FR)**

Rank Xerox (UK) Business Services
(3.10/3.6/3.3.1)

**INSTRUMENTS AND EXPERIMENTAL FEDUI-GEERS**, vol. 24, no. 4, juillet-août 1981, Plenum Publishing Corp., New York, US; V.A. NIKITINSKII et al.: "Source of metal ions"

## Description

L'invention concerne un implanteur d'ions métalliques d'une cathode vers une cible comportant à l'intérieur d'une chambre d'implantation maintenue sous vide au moins une source d'ions à arc sous vide, cet implanteur étant orienté vers des applications industrielles de type métallurgique ou vers la fabrication d'alliages métastables à caractéristiques métallurgiques nouvelles.

Les dispositifs actuels pour l'utilisation métallurgique sont de deux types :

- implanteur d'ions "gazeux" (azote, oxygène, gaz rares ...)
- implanteur d'ions métalliques, à partir de vapeur de sels métalliques et comprenant un séparateur de masse. Dans ces dispositifs, les débits sont faibles et les coûts très élevés.

Les sources d'ions, à partir de vapeur ou de gaz fonctionnent à des pressions relativement élevées, de quelques $10^{-5}$ Pa à quelques $10^{-3}$ Pa (quelques $10^{-3}$ à quelques $10^{-1}$ torr), entrainant soit :

- une extraction des ions de la source de faible surface et par conséquent de faible débit (pour éviter une augmentation importante de pression dans la zone d'accélération)
- une extraction large (utilisée essentiellement pour les ions gazeux), entrainant une pression élevée dans la zone d'accélération avec comme conséquence un nombre important d'interactions ions/neutres et une diminution de l'énergie moyenne des ions ; il en résulte une diminution de la profondeur moyenne de pénétration et un élargissement mal contrôlé de l'implantation.

L'implantation de métal peut également être obtenue par le bombardement ionique (en général avec des ions "gazeux", azote ou gaz rare) d'un dépôt simultané de métal sur le même substrat (évaporation par exemple).

Un dispositif de ce genre est décrit dans un article de T. SATO et al. publié dans la revue JOURNAL VACCUM SCIENCE TECHNOLOGY A4(3) de Mai-Juin 1986, pp.784-787.

Le but de l'invention est de réaliser des implanteurs encore plus performants susceptibles d'applications industrielles à partir de sources d'ions à arc sous vide permettant un fort débit sur une large surface et présentant par rapport aux autres sources les avantages suivants :

- absence de système d'alimentation en gaz,
- fonctionnement sous vide excluant en particulier le pompage différentiel indispensable sur les implanteurs à grand débit,
- faibles dimensions de la source de plasma.

L'émission de flux importants assure ainsi une implantation bien définie en masse et en énergie et à des profondeurs réglables. Sous cet aspect, ces implanteurs s'apparentent à ceux utilisés en microélectronique pour le dopage des matériaux semiconducteurs.

L'implanteur de l'invention est remarquable en ce que la source d'ions à arc sous vide comporte dans cet ordre de la cathode vers la cible au moins ladite cathode, des gâchettes de commande et une anode, une électrode d'extraction et de focalisation et une électrode d'accélération.

On notera que, de la publication NUCLEAR INSTRUMENTS AND METHODS IN PHYSICS RESEARCH, vol.B10/11, n°1, mai 1985, pages 792-795, partie 2, Elsevier Science Publishers B.V., Amsterdam, NL, il est connu des injecteurs d'ions métalliques obtenus, il est vrai, à partir d'une source d'ions à arc sous vide. La source à arc comporte une kathode K et une anode A pour l'extraction.

Selon l'invention, l'électrode d'extraction et de focalisation et l'électrode d'accélération sont polarisées respectivement à très haute et à basse tension.

Le bombardement de la cible par le faisceau ionique engendre un flux d'électrons secondaires. De préférence la source d'ions à arc sous vide comporte des moyens de refroidissement pour absorber les électrons secondaires et/ou l'implanteur comporte à l'intérieur de la chambre d'implantation une électrode suppresseuse qui repousse les électrons secondaires.

Avec une source d'ions commune, l'électrode d'extraction et de focalisation peut être constituée d'une structure multi-orifices définie en fonction de l'optique d'accélération, des tensions appliquées, de la densité et de la masse des ions.

L'implanteur peut comporter plusieurs sources fonctionnant en parallèle, constituées de plusieurs cathodes d'un même (ou de différents) matériau(x).

Selon la forme de cible à implanter, on peut concevoir plusieurs variantes de dispositifs.

Si la cible a une géométrie plane, les sources seront disposées suivant une même ligne avec anode et gachette éventuellement communes. La cible sera de préférence mobile.

S'il s'agit d'implanter l'intérieur (ou l'extérieur) d'une cible de forme cylindrique, les sources seront uniformément réparties sur la périphérie d'une circonférence, orientées ves l'extérieur (ou vers l'intérieur) de cette circonférence et mobiles suivant l'axe du cylindre.

S'il s'agit d'implanter les faces internes (ou externes) d'une cible ayant la forme d'un parallélépipède carré ou rectangle par exemple, les sources seront de la même manière uniformément réparties sur le périmètre d'un carré ou d'un rectangle, mais orientées vers l'extérieur (ou vers l'intérieur) de ce carré ou de ce rectangle et rendues mobiles au moyen d'un système de translation suivant une direction parallèle aux arêtes du parallélépipède ou au moyen de bras articulés pouvant être commandés par ordinateur.

L'élimination des ions indésirables sera effectuée au moyen de divers dispositifs de filtrage.

L'invention sera mieux comprise à l'aide de la description suivante de quelques modes de réalisation de dispositifs donnés à titre d'exemples non limitatifs, ladite description étant accompagnée de dessins qui représentent :

| | |
|---|---|
| La figure 1, | une structure simple d'implanteur conforme à l'invention et constituant la cellule de base. |
| La figure 2, | une structure à plusieurs cellules proches de la précédente, comportant une seule source. |
| La figure 3, | un mode de réalisation à plusieurs sources en parallèle pour l'implantation d'une surface plane. |
| La figure 4, | un mode de réalisation à plusieurs sources en parallèle pour l'implantation de la face interne d'une surface cylindrique. |
| Les figures 5 et 6, | un mode de réalisation à plusieurs sources en parallèle pour l'implantation des faces externes d'un parallélépipède carré ou rectangle avec déplacement des sources au moyen d'un système de translation ou de bras articulés. |
| Les figures 7, 8, 9 et 10, | les schémas de réalisation de divers modes de filtrage. |
| La figure 11, | le schéma d'ensemble d'un équipement industriel d'implanteur métallurgique. |

Les éléments identiques appartenant à différentes figures sont indiqués par les mêmes signes de référence.

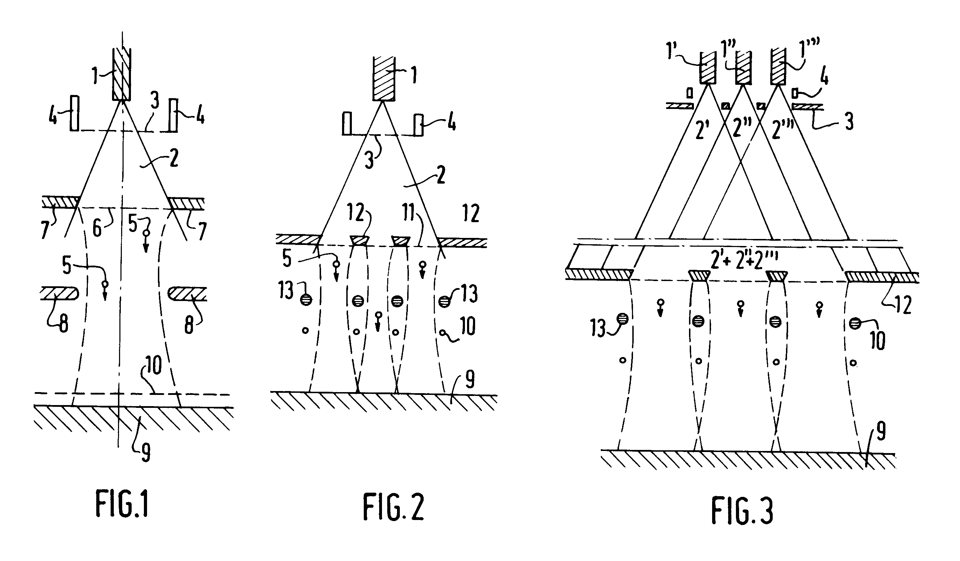

La figure 1 représente la structure simple d'une cellule de base de l'implanteur conforme à l'invention, dont le débit à partir d'une unique source d'ions à arc sous vide est limité par les problèmes d'échauffement thermique, fonction des moyens de refroidissement utilisés et non représentés.

Il en résulte que le débit ramené à l'unité de temps et réglé par le rapport du temps de fonctionnement réel sur le temps total (fonctionnement en mode pulsé) peut varier de quelques mA à plusieur Ampères.

La source d'ions à arc sous vide comporte une cathode 1 émissive d'un plasma 2, une anode 3 et une gachette 4.

L'extraction des ions 5 du plasma est effectuée par un orifice équipé ou non d'une grille d'extraction 6 et la focalisation du faisceau par une simple électrode 7 dont les dimensions sont fonction de celles de la structure. L'accélération des ions est obtenue au moyen de l'électrode d'accélération 8 munie d'un seul orifice de grandes dimensions fonction du débit recherché.

Les ions arrivant sur la cible 9 conduisent à une émission secondaire électronique importante pouvant atteindre plusieurs fois celle du faisceau d'ions incident. Dans ces conditions deux solutions sont possibles :
- absorption de l'énergie sur la partie source d'ions de l'implanteur par simple refroidissement naturel ou forcé (circulation d'un fluide refroidisseur).
- mise en place d'une électrode suppresseuse d'électrons secondaires 10 constituée d'un anneau ou d'une grille de grande transparence qui appliquera sur la cible un faible champ électrique s'opposant à l'émission de ces électrons. Les atomes éventuellement arrachés à cette électrode et déposés sur la cible à traiter sont en faible nombre et dans leur quasi-totalité repulvérisés par le faisceau incident.

La cible peut être mobile de façon à obtenir un dépôt homogène. Un pilotage automatique avec mesure des courants d'ions incidents par des sondes équipées de cages de Faraday disposées en divers points de la cible et un traitement informatique des résultats de mesure peuvent être retenus si la précision de la dose d'implantation est un paramètre critique.

La cible est refroidie par refroidissement naturel ou forcé suivant le type d'utilisation, le taux de travail, le débit et l'énergie des ions implantés. La nature du refroidissement, les moyens mécaniques pour le réaliser, en particulier dans le cas d'implantation d'ions pour traitement de finition de pièces élaborées, sont fonction de la nature de l'utilisation.

La figure 2 représente une structure d'extraction composée de plusieurs cellules proches de la structure précédente et pouvant être disposées comme le fait apparaître le schéma sur lequel on distingue :
- Une source d'ions à arc sous vide commune (cathode 1 émissive du plasma 2, anode 3, gachette 4).
- Une structure d'extraction et focalisation multi-orifices (11, 12) définie en fonction de l'optique d'accélération, des tensions appliquées, de la densité et de la masse des ions 5 et du type de

4

bombardement recherché.

- Une électrode d'accélération multi-orifices 13 pouvant être portée à un potentiel négatif par rapport à la cible de façon à repousser les électrons secondaires de la cible. Une amélioration de l'optique ionique peut être obtenue par l'adjonction d'une deuxième électrode (non représentée) et située entre l'électrode d'extraction 12 et d'accélération 13 permettant de moduler par l'intermédiaire de sa polarisation, la forme du faisceau et en particulier les dimensions et l'homogénéité de la zone bombardée. Cette structure introduit en outre la possibilité, par réglage de sa tension de polarisation, de faire varier la masse des ions par simple changement de la source et sans retouche majeure de l'optique.

- Une cible 9 habituellement à un potentiel nul. Cette cible sera en général mobile afin d'assurer une homogénéité de bombardement. Elle peut être équipée en fonction du type de polarisation de l'électrode d'accélération, d'un système suppresseur d'électrons secondaires 10 (grille, électrode en forme d'entonnoir, etc...).

Une variante intéressante pour l'implantation d'un même matériau à plus fort débit ou sur une plus grande surface ou pour l'implantation simultanée de matériaux de diverses natures est le montage de plusieurs sources d'ions en parallèle et avec des cathodes d'un même ou de différents matériaux comme le montre le schéma de principe de la figure 3.

Si l'on désire par exemple implanter simultanément trois matériaux métalliques $M_1$, $M_2$, $M_3$, les cathodes correspondantes 1′, 1″ et 1‴ émettent respectivement les plasmas 2′, 2″ et 2‴ qui s'enchevêtrent les uns aux autres pour former le mélange 2′ + 2″ + 2‴.

La commande multisources peut être unique, le démarrage d'un arc au moyen de la gachette 4 pouvant entraîner l'amorçage des structures voisines.

L'anode 3 de la multisources peut être commune ou spécifique, le réglage du courant étant effectué par le circuit cathodique.

Le dosage peut être effectué par modulation du courant débité ou/et par réglage de la largeur d'impulsion.

Les autres éléments du schéma : électrodes d'extraction et de focalisation (11,12), électrode d'accélération 13, électrode suppresseuse 10 et cible 9 restent identiques à ceux du schéma à source unique de la figure 2.

Une variante importante exploitant au maximum les avantages précités des sources d'ions à plasma est l'obtention de sources à surface d'extraction de géométries différentes et adaptées au matériel à implanter.

On peut concevoir à titre d'illustration, diverses structures émissives de plasma selon la forme de la cible.

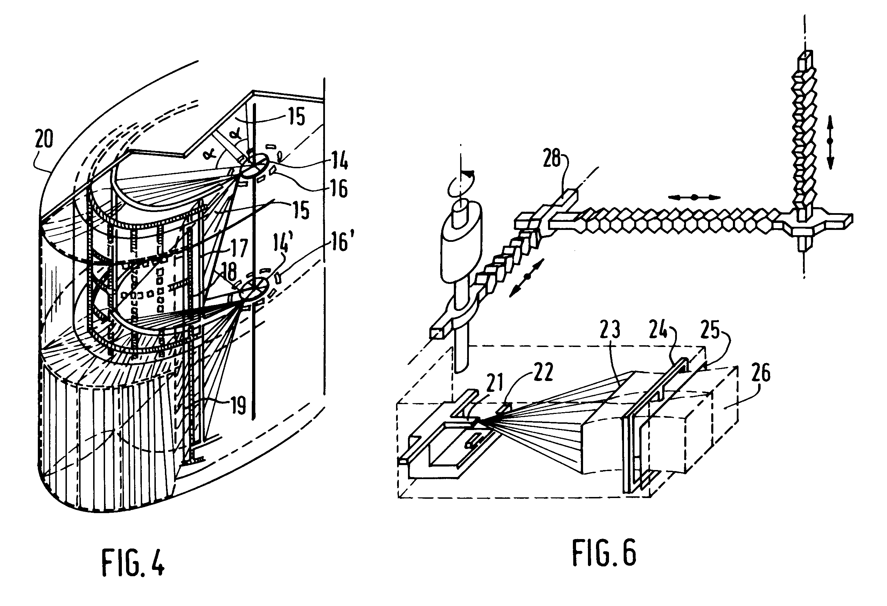

La figure 4 représente schématiquement une structure à zone d'émission cylindrique constituée par un système multicathodes dont les projections de plasma émis par les cathodes disposées suivant un cercle se recoupent sur une surface cylindrique confondue avec l'électrode d'extraction et dépendant du nombre et de la position des cathodes 14, de l'angle au sommet de projection du plasma 15 (voisin de 60°), de la transparence de l'anode 16 et de la distance entre les sections cathodiques.

Le plasma émis recouvre intégralement l'électrode d'extraction 17 et on obtient ainsi une implantation uniforme sur la face interne de la cible cylindrique 20 après passage des faisceaux ioniques à travers l'électrode d'accélération 18 et l'électrode suppresseuse 19.

Les sources cathodiques peuvent être monomatériau ou multimatériaux.

On peut également, pour augmenter la vitesse de dépôt, disposer de plusieurs niveaux de cathodes 14, 14′..., les grilles anodiques 16, 16′... étant ou non communes.

La face interne de la cible cylindrique 20 peut alors être implantée par simple déplacement de l'ensemble source d'ions (ou de la cible).

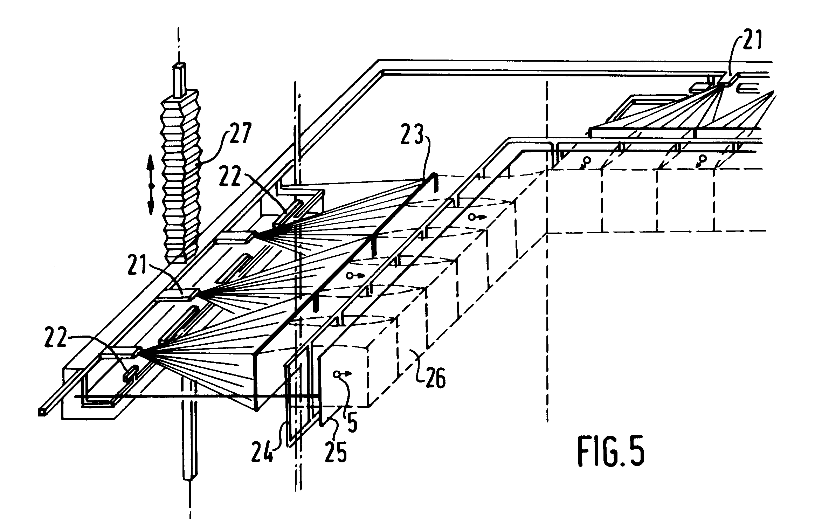

La figure 5 représente le schéma d'une structure pour l'implantation sur la surface externe 26 d'une cible constituée par un tube de section carrée ou rectangulaire ; les sources d'ions (cathodes 21 et anodes 22) sont alors disposées suivant un carré ou un rectangle et susceptible d'être rendues mobiles -par l'adjonction d'un système de translation à soufflet 27- la face externe du tube 26 peut ainsi être implantée après passage des faisceaux ioniques à travers l'électrode d'extraction et de focalisation 23, les électrodes d'accélération 24 et les électrodes suppresseuses 25.

Dans ces structures, l'anode peut être commune et les cathodes avoir une alimentation individuelle (courant et largeur d'impulsion réglés individuellement). Ces ensembles peuvent être mobiles et se déplacer face à la pièce à traiter ainsi qu'il est représenté sur la figure 5, ou inversement être à poste fixe et la cible (pièce à traiter) être mobile.

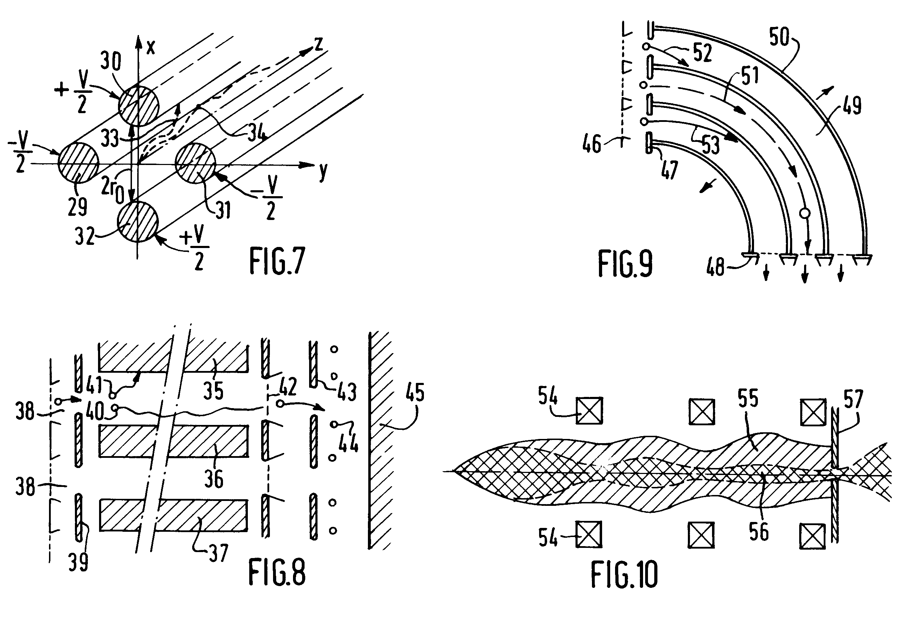

Dans le même esprit, une source d'ions constituée d'une ou de plusieurs cathodes d'un même ou de différents matériaux peut être rendue solidaire d'un bras articulé de technologie compatible avec le vide et l'ultravide représenté sur la figure 6. Ce bras 28 peut être piloté par un ordinateur à partir d'un programme réalisé par exemple à la suite d'essai d'une pièce prototype équipée de capteurs de bombardement ionique. Les quantités d'ions déposées et leur énergie de bombardement seraient alors réglables et adaptées au besoin avec une bonne précision.

On peut noter que la partie à implanter peut, si elle est de grandes dimensions et facilement obturable aux extrémités (cylindre intérieur) constituer la chambre à vide : l'implanteur peut être fixé à l'une des extrémités et le système de pompage à l'autre.

Pour l'implantation sur un objet de forme plus complexe, les sources d'ions internes ou externes sont disposées et orientées de telle façon que l'axe de flux de plasma soit perpendiculaire à la surface et que la densité déposée soit aussi homogène que possible.

Après la description de structures d'implanteurs, il est nécessaire d'expliciter les principes qui régissent le fonctionnement de ces systèmes afin de parvenir aux solutions retenues pour une réalisation industrielle.

Le débit d'ions extrait d'un dispositif de même principe que celui du schéma de la figure 2 est fonction :

- du flux de plasma arrivant sur l'électrode d'extraction (influence des paramètres liés aux sources d'ions -courant d'arc, distance électrode d'extraction- cathode, transparence de la grille anodique).
- de la transparence et de la forme de l'électrode d'extraction.
- du champ électrique appliqué à la limite du plasma (ménisque) dont la forme aura une incidence directe sur la convergence du faisceau extrait et accéléré.
- de la masse des ions extraits.

Dans le cas d'un plasma homogène, la densité de courant extraite $J_i^+$ peut s'écrire :

$$J_i^+ \ \alpha \ \frac{V^{\frac{3}{2}}}{d_c^2} \ \sqrt{\frac{q_i}{M_i^+}}$$

formule dans laquelle V est la tension d'extraction, $d_c$ la distance entre l'électrode d'accélération (ou la surface équivalente) et le ménisque de plasma, $q/M^+$ le rapport de la charge de l'ion à sa masse.

Quant à la convergence du faisceau, elle est fonction de la densité extraite, de la géométrie et des tensions d'accélération.

Dans le cas d'un implanteur multimatériaux, les règles régissant son fonctionnement sont identiques à celles d'un faisceau monomatériau de rapport $q_e/M_e$ tel que :

$$\sqrt{\frac{q_e}{M_e}} = C_1 \sqrt{\frac{q_1}{M_1}} + C_2 \sqrt{\frac{q_2}{M_2}} + \ldots + C_j \sqrt{\frac{q_j}{M_j}}$$

sachant que $C_1$, $C_2$,...$C_j$ sont les concentrations des différentes espèces d'ions et que $C_1 + C_2 + \ldots + C_j = 1$.

Pour certaines applications, il peut être intéressant d'implanter les ions à une profondeur bien déterminée, nécessitant des ions d'énergie constante. Or dans les sources à arc sous vide, la proportion d'ions multicharges est très importante et par conséquent l'énergie des ions peut varier d'un facteur 1, 2, 3 ou même 4. Dans ces conditions, l'implanteur devra disposer d'un système permettant l'élimination des ions d'énergie indésirable.

Pour bénéficier de l'intérêt des sources d'ions utilisant des plasmas d'arc, il est nécessaire de disposer d'un système permettant le passage de large débit, c'est-à-dire à large orifice d'entrée et de sortie.

Les systèmes proposés répondent à cet impératif, bien que globalement, ils ont une réduction sensible du flux d'ions débité par ces systèmes.

Le système schématisé sur la figure 7 représente un filtre à cellules quadripolaires consistant en l'utilisation simultanée de nombreuses cellules constituées de quadripoles. Un quadripole est formé de quatre barreaux cylindriques 29, 30, 31 et 32 simulant un réseau d'équipotentielles de type hyperbolique et polarisés à ± V/2 avec V = $V_1$ + $V_0$ cosωt.

Le mouvement d'un ion à l'intérieur de ce système est donné dans un système normal de coordonnées par le système d'équations :

$$m \frac{d^2x}{dt^2} = - \frac{e}{r^2_0} (V_1 + V_0 \cos\omega t)x$$

$$m \frac{d^2y}{dt^2} = - \frac{e}{r^2_0} (V_1 + V_0 \cos\omega t)y$$

$$m \frac{d^2z}{dt^2} = \text{constante.}$$

Les solutions de ces équations connues sous le nom d'équations de Mathieu sont complexes. On retient simplement que pour une plage réduite des valeurs ($\omega$, $r^2_0$, $V_0$, $V_1$), il existe des conditions de stabilité de la trajectoire oscillante des ions qui pourront ainsi traverser le filtre. Ces ions de masse réduite $m_0 = M_0/q$ (M étant la masse atomique de l'ion et q sa charge électrique) seront les seuls à traverser le filtre et par conséquent à être implantés.

Le mouvement d'ions dans une cellule de filtre quadripolaire est représenté en perspective et schématiquement sur la figure par les trajectoires 33 et 34 en traits interrompus.

La figure 8 montre en coupe longitudinale la disposition d'un ensemble de cellules de filtrage 35, 36 et 37 du type précédemment décrit, entre les électrodes schématisées d'entrée et de sortie de l'implanteur.

On retrouve successivement côté entrée les orifices d'extraction 38 du plasma anodique et les orifices d'accélération 39 des ions injectés 40 et 41. Les ions 40 du métal à implanter de masse réduite $m_0$ traversent le filtre avec une vitesse de glissement constante. Les ions 41 de masse réduite supérieure à $m_0$ sont absorbés par le filtre.

Après traversée des filtres les ions à implanter dans le substrat 45 traversent successivement côté sortie la grille ou orifice 42 destinée à limiter la pénétration du champ électrique d'accélération finale des ions, l'électrode d'accélération des ions à l'énergie souhaitée 43 et l'électrode suppresseuse 44.

La figure 9 représente un filtre à déviation magnétique disposé entre le diaphragme d'entrée 46 et l'électrode d'extraction des ions 47 d'une part et l'électrode d'accélération 48 d'autre part. Ce système utilise les propriétés de déviation des ions par un champ magnétique, c'est-à-dire que le rayon de giration $R_i$ d'un ion de masse réduite m et d'énergie eV dans un champ d'induction B perpendiculaire est donné par l'expression :

$$R = \frac{1}{B} \sqrt{\frac{2mV}{e}}$$

Il est constitué de multicanaux 49 permettant d'injecter sur une large dimension un flux important d'ions. Ces canaux sont limités par des portions de cercle 50 de centre commun permettant le passage des masses ioniques souhaitées, par exemple sur la trajectoire 51 et l'interception des masses ioniques indésirées par exemple sur les trajectoires 52 et 53. A cet effet, le champ magnétique doit être décroissant en raison inverse du rayon du canal de façon à conserver le produit $B \times R$ constant.

Une variante par rapport au système multicanaux est son remplacement par des diaphragmes interceptant les ions n'ayant pas la trajectoire souhaitée. Comme pour le système précédent, les ions sont accélérés à l'entrée du filtre à une énergie moyenne de quelques keV. A la sortie, ils subissent l'accélération principale qui les conduit à l'énergie nominale d'implantation.

La figure 10 représente le schéma de principe d'un filtre à enrichissement en ions d'une même charge électrique.

L'originalité de ce système réside dans le fait qu'il s'applique directement sur le plasma de la source d'ions, c'est-à-dire avant extraction. Il n'a pas les performances des deux systèmes précédents et n'est qu'un enrichissement en ions ayant un rapport $q/M^+$ déterminé.

Il utilise la propriété de canalisation du plasma par les lignes de champ magnétique produit par les bobines 54 : à des lignes de force convergentes correspond une réduction de section du plasma. Ce phénomène est en général expliqué par la limitation de diffusion des électrons du plasma qui, à leur tour, attirent les ions, de façon à maintenir la condition de neutralité du plasma.

L'expérience montre que pour des valeurs de champ magnétique faibles et pour un plasma projeté (type plasma d'arc), les ions de masse équivalente faible sont plus sensibles à cet effet que les ions de masse plus lourde.

Le plasma est ainsi séparé suivant l'axe des bobines 54 en un plasma enrichi en masses "lourdes" 55 les plus éloignées de l'axe et en un plasma de masses "légères" 56 les plus rapprochées de l'axe. Ce dernier, de section plus faible, est extrait à travers le diaphragme d'interception 57 et s'épanouit à nouveau dès la sortie de ce diaphragme puisqu'il n'est plus soumis à l'action du champ magnétique.

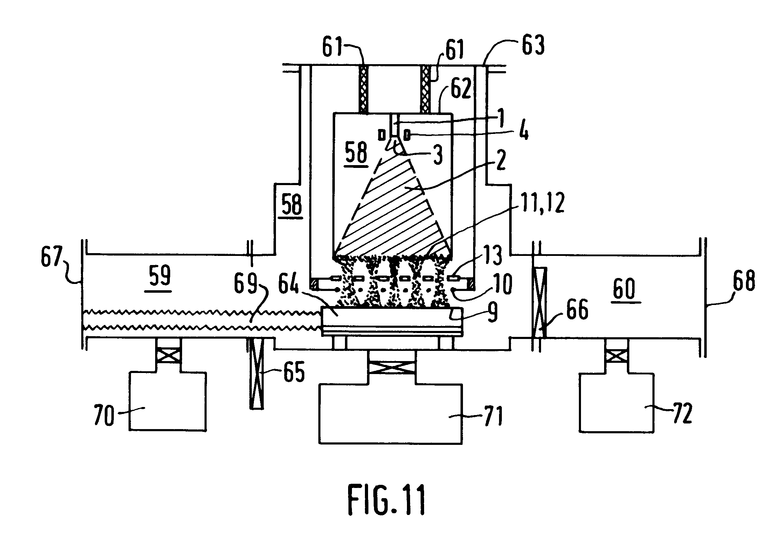

Le schéma de la figure 11 donne un exemple d'un équipement industriel d'implanteur métallurgique. Pour la clarté du schéma, on décrit une installation munie d'une source unique pour implanter une cible de géométrie plane.

On distingue dans cette installation les parties suivantes :
- la chambre d'implantation 58 qui permet d'effectuer le vide dans l'installation. Pour l'équipement industriel représenté, nécessitant un fonctionnement continu avec un nombre important de pièces, elle est équipée de deux sas 59, 60 qui permettent l'introduction des matériels à implanter et de leur support, ainsi que des servitudes (refroidissement, mouvement, mesure du courant et de la température). La cible sera maintenue à température constante par circulation d'un fluide non représenté et équipée des instruments de mesure nécessaires à la connaissance des paramètres d'utilisation.
- la source d'ions à THT positive et par conséquent montée sur isolateurs 61. Cette source conforme au schéma de la figure 2 comporte les diverses électrodes déjà décrites : cathode 1 émissive du plasma 2 et anode 3, électrodes de déclenchement 4 et éventuel système anti-microprojection (non représenté). Ces électrodes sont refroidies au moyen d'un dispositif non représenté de circulation d'un fluide ou d'un caloduc pour la cathode et l'anode.

Cet ensemble est solidaire d'une même embase 62 sur laquelle sont montés les isolateurs 61.

La suite de l'installation comporte :
- la grille d'extraction-focalisation 11, 12, l'électrode d'accélération 13 et l'électrode suppresseuse 10 de formes appropriées et strictement positionnées les unes par rapport aux autres. Un montage possible peut être la fixation à partir du même support (la paroi supérieure 63 de la chambre d'implantation) de l'ensemble de ces électrodes portées à des potentiels très différents.
- la cible 9 portée par le support cible 64 qui doit satisfaire un certain nombre d'impératifs d'homogénéité et de contrôle de la dose implantée, de dissipation de l'énergie déposée et de commodité de montage des pièces ou composants à monter.

Le contrôle d'homogénéité est effectué par des sondes non représentées (cages de Faraday) réparties en différents points de la cible et reliées à un ordinateur qui pilotera la vitesse de dépôt et l'exposition de la cible en fonction de la dose reçue.

La dissipation de l'énergie est dans certaines utilisations le point le plus critique. Dans la majeure partie des cas, le contrôle de température sera effectué sur des sondes représentatives des cibles à traiter et couplées à une centrale de mesure, comme les sondes de doses. Le temps de séjour de la cible dans le faisceau sera alors fonction de la dose reçue et de la température, les paramètres étant la position de la cible et le taux de travail de l'implanteur. L'évacuation de l'énergie déposée est fonction de la nature de la cible. Chaque cible sera l'objet d'un traitement spécifique, compatible avec les spécifications du dépôt et sa qualité. La matrice du support-cible sera fonction de l'utilisation et la méthode de refroidissement en dépendra : refroidissement par circulation de fluide en contact direct avec le support-cible, refroidissement par caloduc, refroidissement par circulation de gaz. Des sondes pourraient être immergées pour suivre l'évolution de la température côté refroidissement et permettre ainsi la mise en évidence des anomalies.

Le porte-cible 64 introduit dans l'enceinte par l'intermédiaire d'un système de sas est monté sur un système mobile à soufflet à l'intérieur duquel passent également les fluides de refroidissement et les systèmes de mesures (température, courant). Les sas d'introduction nécessaires pour les équipements industriels et les équipements ultra-vide de laboratoire sont composés d'une enceinte 59, 60 fermée par une vanne à large passage 65, 66 et d'une face démontable 67, 68 équipée du système de mise en mouvement de la cible. Sur les équipements industriels, la fermeture et l'ouverture du sas sont rapides et simples ; les déplacements de la face démontable peuvent être faits sur rails afin de faciliter la mise en place du matériel à implanter. Le système à deux sas représenté sur la figure permet la possibilité de dégazage dans l'un d'eux.

Après rechargement, les matériels à implanter peuvent être étuvés afin d'éliminer la majeure partie du dégazage avant introduction dans la chambre d'implantation.

Après introduction dans ladite chambre, le porte-cible 64 peut être mis en mouvement à partir de points fixes solidaires de l'enceinte à l'aide d'un excentique ou directement par l'intermédiaire du système souple 69 représenté sur la figure.

Le système de pompage 70, 71, 72 dont le type et la nature sont fonction de l'utilisation doit être en tout état de cause isolable de l'enceinte et dans la mesure du possible, ne pas rétrodiffuser des vapeurs d'huile en raison des dérives probables des produits traités et des problèmes de tenue en tension entre les

EP 0 307 017 B1

différentes électrodes.

En plus des utilisations d'implantation d'ions métalliques, l'implanteur métallurgique de l'invention peut être utilisé pour réaliser des dépôts de type "réactif". A cet effet, le dispositif fonctionnant à tension d'accélération nulle, la source d'ions devient une source de plasma qui après avoir traversé l'ensemble d'accélération va se déposer sur la cible. Le maintien d'une pression résiduelle d'un gaz réactif déterminé ($O_2$, $N_2$...) permet d'obtenir des couches de composés (oxydes, nitrures...).

Le taux de réactivité du dépôt est fonction de la pression p, de la densité temporelle du dépôt, du courant de source $I_s$ et de la surface du dépôt.

L'ensemble pouvant être piloté par ordinateur, on obtient un composé déterminé par réglage de p ou de $I_s$ ou de $T_s$ (largeur d'impulsion).

Ce dépôt peut être simultanément bombardé par des ions de même nature ou de nature différente pour être "mélangés" au support ou être dopé.

Dans le même type d'application, on peut, après implantation, déposer sur la surface un dépôt protecteur du substrat implanté avec (ou sans) implantation initiale pour un meilleur accrochage de la couche protectrice. Comme on vient de le voir, l'implanteur peut être utilisé comme système de métallisation du matériau cathodique en l'absence de toute tension d'accélération.

## Revendications

1. Implanteur métallurgique d'ions métalliques d'une cathode (1) vers une cible (9) comportant, à l'intérieur d'une chambre d'implantation maintenue sous vide au moins une source d'ions à arc sous vide, caractérisé en ce que ladite source d'ions comporte dans cet ordre de la cathode (1) vers la cible (9), au moins ladite cathode (1), des gâchettes de commande (4) et une anode (3), une électrode d'extraction et de focalisation (7) et une électrode d'accélération (8).

2. Implanteur selon la revendication 1, caractérisé en ce qu'il comporte à l'intérieur de la chambre d'implantation pour repousser les électrons secondaires, une électrode suppresseuse (10) disposée dans le faisceau d'ions métalliques entre ladite électrode d'accélération (8) et ladite cible (9).

3. Implanteur selon l'une des revendications 1 ou 2, caractérisé en ce que ladite électrode de focalisation ne comporte qu'un seul orifice.

4. Implanteur selon l'une des revendications 1 ou 2, caractérisé en ce que ladite électrode de focalisation est constituée d'une structure multi-orifices.

5. Implanteur selon l'une des revendications 1 à 4, caractérisé en ce qu'il comporte plusieurs sources fonctionnant en parallèle, constituées de plusieurs cathodes (1', 1'', 1''').

6. Implanteur selon la revendication 5, caractérisé en ce que lesdites cathodes (1', 1'', 1''') sont faites de différents matériaux ($M_1$, $M_2$, $M_3$).

7. Implanteur selon l'une des revendications 5 ou 6, caractérisé en ce que lesdites sources en parallèle sont disposées suivant une même ligne avec anode (3) et gâchette (4) commune pour l'implantation d'une cible ayant une géométrie plane.

8. Implanteur selon l'une des revendications 5 ou 6, caractérisé en ce que lesdites sources en parallèle sont disposées sur un ou plusieurs niveaux, avec cathodes (14) et anodes (16) uniformément réparties sur la périphérie d'une courbe fermée ou d'un polygone, orientées vers l'intérieur ou vers l'extérieur de ladite courbe ou dudit polygone, ladite disposition des sources étant rendue mobile pour l'implantation de la surface externe ou interne d'une cible tubulaire de forme cylindrique (20) ou polygonale.

9. Implanteur selon la revendication 8, caractérisé en ce que ladite disposition des sources est rendue mobile au moyen d'un système (27) de translation suivant une direction parallèle à l'axe de ladite cible tubulaire.

10. Implanteur selon la revendication 8, caractérisé en ce que ladite disposition des sources est rendue mobile au moyen de bras articulés (28) pouvant être commandés par ordinateur.

**11.** Implanteur selon l'une des revendications précédentes, caractérisé en ce qu'il peut être muni d'un système de filtrage permettant l'élimination des ions d'énergie indésirable.

**12.** Implanteur selon la revendication 11, caractérisé en ce que ledit système de filtrage (54, 57) est disposé en deç de l'électrode d'extraction et agit directement sur le plasma émis par la source en utilisant la propriété de canalisation dudit plasma par les lignes de force d'un champ magnétique.

**13.** Implanteur selon la revendication 11, caractérisé en ce que ledit système de filtrage est disposé au-delà de l'électrode d'extraction et est constitué par des cellules quadripolaires (35, 36, 37) polarisées en haute fréquence ou par des multicanaux circulaires à déviation magnétique (49).

**14.** Implanteur selon l'une des revendications 1 à 10, caractérisé en ce que la tension d'accélération étant nulle, ladite source d'ions à arc sous vide est utilisée comme source de plasma qui, après traversée de l'ensemble d'accélération, va se déposer sur la cible, l'introduction d'une pression résiduelle d'un gaz réactif déterminé tel que $O_2$, $N_2$... dans ladite chambre d'implantation permettant d'obtenir des dépôts de type "réactif" tels qu'oxydes, nitrures...).

**Claims**

**1.** A metallurgical implementation apparatus for implanting metal ions, from a cathode (1) to a target (9), comprising within an implantation chamber held under a vacuum, at least one vacuum arc ion source, characterized in that said ion source successively comprises, viewed in the direction from the cathode (1) to the target (9), at least said cathode (1), control gates (4) and an anode (3), an extracting and focusing electrode (7) and an accelerating electrode (8).

**2.** An implantation apparatus as claimed in Claim 1, characterized in that it comprises within the implantation chamber a suppressing electrode (10) for suppressing secondary electrons, said suppressing electrode being arranged in the metal ion beam between the accelerating electrode (8) and the target (9).

**3.** An implantation apparatus as claimed in Claim 1 or 2, characterized in that the said focusing electrode comprises only one orifice.

**4.** An implantation apparatus as claimed in Claim 1 or 2, characterized in that the said focusing electrode comprises a multi-orifice structure.

**5.** An implantation apparatus as claimed in any of the Claims 1 to 4, characterized in that it comprises several sources operating in parallel and constituted by several cathodes (1', 1'', 1''').

**6.** An implantation apparatus as claimed in Claim 5, characterized in that the cathodes (1', 1'', 1''') are made of different materials ($M_1$, $M_2$, $M_3$).

**7.** An implantation apparatus as claimed in Claim 5 or 6, characterized in that said parallel sources are disposed along the same line with a common anode (3) and gate (4) for the implantation of a target having a planar geometry.

**8.** An implantation apparatus as claimed in Claim 5 or 6, characterized in that the said parallel sources are disposed at one or several levels, cathodes (14) and anodes (16) being uniformly distributed along the periphery of a closed curve or polygon and being directed towards the interior or exterior of the said curve or polygon, the said arrangement of sources being made movable for the implantation of the external or internal surface of a tubular target of cylindrical (20) or polygonal shape.

**9.** An implantation apparatus as claimed in Claim 8, characterized in that the said arrangement of sources is made movable by means of a translation system (27) in a direction parallel to the axis of the said tubular target.

**10.** An implantation apparatus as claimed in Claim 8, characterized in that the said arrangement of sources is made movable by means of pivoted arms (28) which can be controlled by a computer.

**11.** An implantation apparatus as claimed in any one of the preceding Claims, characterized in that it can be provided with a filtering system for eliminating ions of undesired energy.

**12.** An implantation apparatus as claimed in Claim 11, characterized in that the said filtering system (54, 57) is arranged in front of the extracting electrode and acts directly on the plasma emitted by the source by utilizing the property of canalization of the said plasma by the lines of force of a magnetic field.

**13.** An implantation apparatus as claimed in Claim 11, characterized in that the said filtering system is arranged behind the extracting electrode and consists of quadrupolar cells (35, 36, 37) polarized at high frequency or of circular magnetic deviation multichannels (49).

**14.** An implantation apparatus as claimed in any one of the Claims 1 to 10, characterized in that the acceleration voltage being zero, the said vacuum arc ion source is used as a plasma source which, after traversal of the accelerating assembly, will be deposited on the target, the introduction of a residual pressure of a certain reactive gas, such as $O_2$, $N_2$ etc. in the said implantation chamber permitting of obtaining deposits of the "reactive" type, such as oxides, nitrides etc.

## Patentansprüche

**1.** Anlage für Metallionenimplantation von einer Kathode (1) nach einem Target (9), mit einer evakuierten Implantationskammer, in der wenigstens eine evakuierte Bogenionenquelle angeordnet ist, dadurch gekennzeichnet, daß die Ionenquelle in der Reihenfolge von der Kathode (1) nach der Targetplatte (9), wenigstens die Kathode (1), Steuerelektroden (4) und eine Anode (3), eine Extraktions- und Fokussierelektrode (7) und eine Beschleunigungselektrode (8) enthalt.

**2.** Implantationsanlage nach Anspruch 1, dadurch gekennzeichnet, daß sie im Inneren der Implantationskammer zum Unterdrücken der Sekundärelektronen eine Unterdrückungselektrode (10) im Metallionenbündel zwischen der Beschleunigungselektrode (8) und der Targetplatte (9) enthält.

**3.** Implantationsanlage nach einem der Ansprüche 1 oder 2, dadurch gekennzeichnet, daß die Fokussierelektrode nur eine einzige Mündung enthält.

**4.** Implantationsanlage nach einem der Ansprüche 1 oder 2, dadurch gekennzeichnet, daß die Fokussierelektrode aus einer Mehrmündungsstruktur besteht.

**5.** Implantationsanlage nach einem der Ansprüche 1 bis 4, dadurch gekennzeichnet, daß sie mehrere parallel arbeitende Quellen enthält, die aus mehreren Kathoden (1', 1''. 1''') bestehen.

**6.** Implantationsanlage nach Anspruch 5, dadurch gekennzeichnet, daß die Kathoden (1', 1'', 1''') aus verschiedenen Werkstoffen ($M_1$, $M_2$, $M_3$) hergestellt sind.

**7.** Implantationsanlage nach einem der Ansprüche 5 oder 6, dadurch gekennzeichnet, daß die parallelen Quellen auf einer selben Linie mit der Anode (3) und der Steuerelektrode (4) gemeinsam für die Implantation einer Targetplatte mit einer flachen Geometrie angeordnet sind.

**8.** Implantationsanlage nach einem der Ansprüche 5 oder 6, dadurch gekennzeichnet, daß die parallelen Quellen auf einem oder mehreren Pegeln angeordnet sind, wobei die Kathoden (14) und die Anoden (16) einheitlich auf dem Umkreis einer geschlossenen Kurve oder eines Vielecks verteilt und nach dem Inneren oder nach der Außenseite der Kurve oder des Vielecks gerichtet sind, wobei die Aufstellung der Quellen für die Implantation der externen Fläche oder der internen Fläche einer rohrförmigen Targetplatte mit zylindrischer Form (20) oder Polygonform verschiebbar gemacht wird.

**9.** Implantationsanlage nach Anspruch 8, dadurch gekennzeichnet, daß die Anordnung der Quellen mit Hilfe eines Translationssystems (27) in einer Richtung parallel zur Achse der rohrförmigen Targetplatte verschiebbar gemacht wird.

**10.** Implantationsanlage nach Anspruch 8, dadurch gekennzeichnet, daß die Anordnung der Quellen mit Hilfe gelenkiger Hebel (28) verschiebbar gemacht wird, die mit Hilfe eines Computers gesteuert werden können.

**11.** Implantationsanlage nach einem oder mehreren der vorangehenden Ansprüche, dadurch gekennzeichnet, daß sie mit einem Filtersystem versehen werden kann, die die Beseitigung von Ionen mit unerwünschter Energie möglich macht.

**12.** Implantationsanlage nach Anspruch 11, dadurch gekennzeichnet, daß das Filtersystem (54, 57) vor der Extraktionselektrode angeordnet ist und direkt auf das von der Quelle emittierte Plasma einwirkt, wobei die Eigenschaft der Kanalisierung des Plasmas durch die Kraftlinien eines Magnetfelds ausgenutzt wird.

**13.** Implantationsanlage nach Anspruch 11, dadurch gekennzeichnet, daß das Filtersystem hinter der Extraktionselektrode angeordnet ist und aus Quadripolarzellen (35, 36, 37) besteht, die bei hoher Frequenz oder durch die kreisförmigen Mehrkanäle mit Magnetabweichung (49) polarisiert sind.

**14.** Implantationsanlage nach einem der Ansprüche 1 bis 10, dadurch gekennzeichnet, daß die Beschleunigungsspannung gleich Null ist, wobei die hohe Ionenquelle mit Vakuum als Plasmaquelle verwendet wird, die nach dem Durchsetzen der Beschleunigungseinheit auf der Targetplatte niederschlägt, wobei die Einführung eines Restdrucks eines bestimmten reaktiven Gases wie $O_2$, $N_2$ ... in der Implantationskammer das Erzeugen von Niederschlägen vom Typ "reaktiv" (wie z.B. Oxide, Nitride ...) ermöglicht.

FIG.1  FIG.2  FIG.3

EP 0 307 017 B1

FIG.6

FIG.4

FIG.5

EP 0 307 017 B1

FIG.7

FIG.8

FIG.9

FIG.10

EP 0 307 017 B1

FIG.11

EP 0 307 017 B1